# EUROPÄISCHE PATENTSCHRIFT

(11) **EP 1 444 724 B1**
(45) Veröffentlichungstag und Bekanntmachung des Hinweises auf die Patenterteilung: **24.01.2007**
(21) Anmeldenummer: 02776865.4
(22) Anmeldetag: 29.10.2002
(51) Int. Cl.: H01L 21/033, H01L 21/027, C23C 16/26, H01L 21/314, C23C 16/27, G03F 7/09, G03F 7/11

(54) **PHOTOLITHOGRAPHISCHES STRUKTURIERUNGSVERFAHREN MIT EINER DURCH EIN PLASMAVERFAHREN ABGESCHIEDENEN KOHLENSTOFF-HARTMASKENSCHICHT MIT DIAMANTARTIGER HÄRTE**
METHOD FOR PHOTOLITHOGRAPHIC STRUCTURING BY MEANS OF A CARBON HARD MASK LAYER WHICH HAS A DIAMOND-LIKE HARDNESS AND IS PRODUCED BY MEANS OF A PLASMA-ENHANCED DEPOSITION METHOD
PROCEDE DE STRUCTURATION PHOTOLITHOGRAPHIQUE AU MOYEN D'UNE COUCHE MASQUE DURE, DE DURETE ANALOGUE AU DIAMANT, OBTENUE PAR DEPOT ASSISTE AU PLASMA

(30) Priorität: 29.10.2001 DE 10153310
(43) Veröffentlichungstag der Anmeldung: 11.08.2004
(73) Patentinhaber: Infineon Technologies AG, 81669 München (DE)
(72) Erfinder: CZECH, Guenther, 01465 Langebrück (DE); FUELBER, Carsten, 01099 Dresden (DE); KIRCHHOFF, Markus, 01458 Ottendorf-Okrilla (DE); STEGEMANN, Maik, 01157 Dresden (DE); VOGT, Mirko, 01307 Dresden (DE); WEGE, Stephan, 01474 Weissing (DE)
(74) Vertreter: Graf Lambsdorff, Matthias
(86) Internationale Anmeldenummer: PCT/DE2002/004034
(87) Internationale Veröffentlichungsnummer: WO 2003/038875

(56) Entgegenhaltungen:
- EP-A- 1 271 546
- EP-B- 0 808 481
- US-A- 5 656 128
- US-A- 5 981 398
- US-A- 6 030 541
- US-A- 6 091 081
- US-B1- 6 316 329

## Beschreibung

Die vorliegende Erfindung bezieht sich generell auf das Gebiet der Strukturierungsverfahren für die Halbleitertechnologie, bei welchen eine Schicht an der Oberfläche eines Substrats strukturiert werden soll. Insbesondere betrifft die Erfindung dabei ein Strukturierungsverfahren nach dem Oberbegriff des Patentanspruchs 1.

Bei der Fertigung von Halbleiterbauelementen tritt häufig das Erfordernis auf, dass in einem Verfahrensschritt eine Strukturierung durch Ätzen durchgeführt werden muss, bei der die zu entfernenden Abschnitte mindestens teilweise durch ein Siliziumoxid oder Siliziumnitrid gebildet werden. Ein Beispiel hierfür ist die Herstellung von Halbleiterspeicherzellen, welche einen Grabenkondensator und einen Auswahltransistor aufweisen. Während der Grabenkondensator auf einer Seite mit dem Auswahltranistor elektrisch durch eine vergrabene Brücke ("buried strap") verbunden wird, wird auf der anderen Seite des Grabenkondensators ein Isolationsgebiet (STI, "shallow trench isolation") erzeugt, durch welches der Grabenkondensator von einer benachbarten Speicherzelle elektrisch isoliert wird. Die Erzeugung des STI-Isolationsgebiets erfolgt durch einen Strukturierungsschritt, bei welchem ein Oberflächenabschnitt entfernt wird, der durch einen Teilabschnitt des zuvor erzeugten Grabenkondensators gebildet wird. Dies bedeutet, dass nicht nur Silizium geätzt werden muss, sondern auch Siliziumoxid, da der Grabenkondensator in seinem oberen Abschnitt einen Isolationskragen aus Siliziumoxid aufweist. Da sich an der Oberfläche des zu entfernenden Abschnitts zumeist eine Siliziumnitridschicht befindet, muß somit durch den Ätzprozeß auch Siliziumnitrid geätzt werden können.

Bezüglich der Erzeugung von STI-Isolationsgebieten bei der Herstellung der genannten Speicherzellen wird beispielhaft auf die deutschen Offenlegungsschriften DE 199 41 148 A1 und DE 199 44 012 A1 verwiesen.

Angesichts der lateralen Dimensionen des Grabenkondensators, die in der Größenordnung von 100 - 200 nm liegen, stellt der genannte Prozess der Erzeugung des STI-Isolationsgebiets höchste Anforderungen an die Lagegenauigkeit, Maßhaltigkeit und Flankensteilheit des anzuwendenden Ätzprozesses, da sich die zu erzeugende Flanke der zu ätzenden Vertiefung mit äu-ßerst geringem lateralem Lagefehler innerhalb des Grabenkondensators auf der der Leitungsbrücke abgewandten Seite befinden muss.

Zur Erzeugung kleinster Strukturen auf der Halbleiteroberfläche als auch zur Einhaltung geringster Variationen der Strukturbreiten über den Chip, den Wafer oder das Los ist es notwendig, dass die Reflexion von Licht der Belichtungswellenlänge an der Waferoberfläche (Grenzfläche Photolack - Substrat) möglichst vollständig unterbunden wird, um störende Interferenzeffekte auszuschalten. Dies gilt besonders für Belichtungswellenlängen bei und unter 248 nm (193 nm, 157 nm) aufgrund der zunehmenden Reflektivität der Substrate. Weiterhin muss zur Erzielung einer möglichst großen Tiefenschärfe bei der Belichtung die zu belichtende Lackschicht einerseits möglichst dünn sein. Um die Strukturübertragung, insbesondere bei Kontaktlöchern, zu realisieren, ist jedoch angepaßt an die zu ätzende Schichtdicke eine ausreichende Maskendicke und/oder eine hohe Ätzresistenz der Maske (Selektivität der Maske) notwendig.

Diesem Problem kann durch die folgenden im Stand der Technik bekannten Verfahren begegnet werden, die sämtlich darauf beruhen, dass eine zusätzliche Hilfsschicht verwendet wird.

In der EP 0 492 253 A1 ist ein Photostrukturierungsverfahren beschrieben, bei welchem zwei Photoresistschichten verwendet werden. Eine obere, relativ dünne Photoresistschicht (Topresist) wird nach der Strukturierung mit einem siliziumhaltigen Agens resistent gegen Trockenätzen im Sauerstoffplasma gemacht. In diesem nachfolgenden Trockenätzschritt wird die Struktur des Topresists mit dem exakten Maß der für die Strukturierung verwendeten Maske und mit senkrechten Flanken in eine untere, relativ dicke Photoresistschicht (bottom resist) übertragen. In Folge der chemischen Verstärkung des strukturiertem Topresists hat dieses Verfahren die Bezeichnung CARL (Chemische Aufweitung von Resist Linien) erhalten. Der Bottomresist dient während der Ätzung des Substrats als eigentliche Maske. Der Bottomresist selbst muss anschließend in einem speziellen Ätzverfahren, beispielsweise mit O₂ oder SO₂ entfernt werden. Derartige Photoresistmasken haben insbesondere während der Ätzung von Kontaktlöchern mit sehr hohem Aspektverhältnis den entscheidenden Nachteil, dass sich die aus dem Resist während der Ätzung entstehenden Polymere nicht kontrollieren lassen. Dies kann für sehr kleine Strukturen zu einer starken Reduktion des Ätzprozessfensters führen.

Des Weiteren sind Verfahren bekannt, bei denen als Hilfsschicht eine sogenannte Hartmaske verwendet wird. In der Deutschen Patentschrift DE 195 04 434 C1 wird eine Photolackschicht auf einer Maskenschicht aus einem siliziumhaltigen Dielektrikum entsprechend einer vorgegebenen Struktur belichtet und unter Verwendung von Lösungsmittel strukturiert. Die Photolackschicht wird verwendet, um die Struktur in die Maskenschicht zu übertragen, wobei ein modifiziertes anisotropes Plasmaätzverfahren eingesetzt wird, bei welchem der chemische Anteil der Ätzung dominiert. Anschließend wird der Photolack entfernt und die strukturierte Maskenschicht kann als Maske für ein Trockenätzverfahren zur Strukturierung des Substrats verwendet werden. Es sind ferner ähnliche Verfahren bekannt, bei denen Hartmasken aus Polysilizium eingesetzt werden. Die Polysilizium-Hartmaskenschicht wird dabei in einem Ofenprozess bei Temperaturen zwischen 600° C und 700° C abgeschieden, wodurch Probleme aufgrund der Wärmebelastung der bereits erzeugten Schaltungsstrukturen resultieren können. Ein generelles Problem der eben genannten Hartmaskenmaterialien liegt darin, dass sie in einem speziellen Ätzschritt geöffnet werden müssen. Ein weiterer Nachteil liegt darin, dass sie zumeist - wie bei dem Beispiel Polysilizium - nicht als antireflektierende Schichten tauglich sind.

Bislang sind antireflektierende organische Schichten bekannt, die durch Aufschleuderverfahren vor der eigentlichen Belackung mit dem zu belichtenden Photoresist mit einem Track auf die Oberfläche des Wafers gebracht werden. Diese Schichten können jedoch nicht als Hartmaskenschichten verwendet werden und die Reflexion lässt sich auch nur bis auf ca. 10 % reduzieren. Des Weiteren sind anorganische Oxynitride, die mit einem CVD-Verfahren aufgebracht werden, als antireflektierende Schichten bekannt, wobei sich die Reflexion nicht unter 10 % reduzieren lässt. Zumindest für den Einsatz bei Oxidätzprozessen sind diese Schichten ebenfalls nicht als Hartmaskenschichten tauglich.

Es ist weiterhin aus den Druckschriften US-PS 5,378,316, US-PS 5,656,128 und EP 0 808 481 B1 bekannt, zur photolithographischen Strukturerzeugung eine Hartmaskenschicht aus Kohlenstoff einzusetzen. Es wird darin vorgeschlagen, die Kohlenstoff-Hartmaskenschicht durch ein PECVD (plasma enhanced chemical vapor deposition)-Verfahren abzuscheiden, wodurch gezielt Wasserstoff in die Kohlenstoffschicht eingebaut werden kann. Bei diesem Verfahren werden üblicherweise Drücke von ca. 133,3 - 1333 Pa des Plasmas in der Reaktorkammer und Substrattemperaturen um die 400° C eingestellt. Durch die PECVD-Abscheidung entsteht eine hoch verdichtete antireflektierende Schicht, die bereits recht gute Eigenschaften als Hartmaske aufweist und deren Brechungsindizes durch das Verfahren einstellbar sind. Damit ist ein Abgleich zwischen optischem Verhalten und Ätzresistenz möglich. Die Herstellung der Kohlenstoff-Hartmaskenschicht durch das PECVD-Verfahren liefert gute Ergebnisse, solange die Abscheidung auf planaren Strukturen erfolgen kann. Wenn die Abscheidung jedoch auf einer topografischen Struktur zu erfolgen hat, welche Löcher, Gräben oder Erhebungen aufweist, so beinhaltet das PECVD-Verfahren den Nachteil, dass die Kohlenstoffschicht nicht optimal in die Gräben und Löcher eingefüllt wird und zudem auch keine planarisierende Wirkung aufweist. Ein weiterer Nachteil ist, dass im allgemeinen die Hartmaskenqualität der Kohlenstoff-Hartmaskenschicht mit zunehmender Härte, d.h. zunehmenden Diamantanteil, in der Schicht und mit sinkendem Wasserstoffgehalt zunimmt, beide Kriterien jedoch mit dem PECVD-Verfahren nur begrenzt realisierbar sind. So ist der Diamantanteil der mit PECVD abgeschiedenen Schichten nahezu Null und der Wasserstoffgehalt kann nicht unter 15% gedrückt werden.

Aus der bereits genannten US-PS 5,378,316 ist zudem bekannt, die Kohlenstoff-Hartmaskenschicht nicht direkt über den Photolack zu strukturieren, sondern über eine aus SiO₂ gefertigte Zwischenschicht. Dies hat den Vorteil, dass die Photolackschicht dünner ausgeführt werden kann, wodurch ein größerer Spielraum bei der Einstellung der Prozeßbedingungen der Lithographie bei der Strukturierung des Photolacks gewonnen werden kann.

In der US-PS 5,981,398 wird ein Strukturierungsverfahren mit einem chlorhaltigen Plasma unter Verwendung einer Hartmaske beschrieben. Als Hartmaskenmaterial wird unter anderem eine amorphe Kohlenstoffschicht beschrieben, die durch ein HDP-(high density plasma)CVD-Verfahren hergestellt wird. Die darin beschriebenen Ätzprozesse dienen der Herstellung und Strukturierung von elektrisch leitfähigen Materialien, insbesondere (A1-) Leiterbahnmaterialien. Es wird jedoch nicht genauer beschrieben, wie die Prozessführung erfolgen soll, damit eine Kohlenstoff-Hartmaskenschicht hoher Qualität erzielt werden kann.

Es ist demzufolge Aufgabe der vorliegenden Erfindung, ein verbessertes Herstellungsverfahren für eine Kohlenstoff-Hartmaskenschicht anzugeben, mit welchem die Schicht einerseits auf jeder beliebigen Topographie abgeschieden werden kann und andererseits die Schichteigenschaften besser zwischen optimalen antireflektierenden Eigenschaften und optimalen Ätzresistenzeigenschaften eingestellt werden können.

Diese Aufgabe wird durch die kennzeichnenden Merkmale des Patentanspruchs 1 gelöst. Vorteilhafte Weiterbildungen und Ausgestaltungen sind in den Unteransprüchen angegeben.

Ein wesentlicher Gedanke der Erfindung besteht darin, die Kohlenstoff-Hartmaskenschicht durch ein plasmaunterstütztes Abscheideverfahren abzuscheiden und die Abscheidung derart durchzuführen, dass die Kohlenstoff-Hartmaskenschicht in mindestens einem Schichtdickenabschnitt eine einem Diamanten vergleichbare Härte aufweist.

Dabei kann vorgesehen sein, dass sich der genannte Schichtdickenabschnitt über die gesamte Kohlenstoff-Hartmaskenschicht erstreckt und somit die Kohlenstoff-Hartmaskenschicht über ihre gesamte Dicke optimale diamantähnliche Härteeigenschaften und Ätzresistenzeigenschaften aufweist. Es ist aber ebenso möglich, dass die Schicht nur in einem begrenzten Schichtdickenabschnitt eine diamantähnliche Härte aufweist und in den übrigen Schichtdickenabschnitten eine davon abweichende Härte aufweist.

Wenn im folgenden des öfteren die Termini "diamantartig" oder "graphitartig" verwendet werden, so bezieht sich dies nicht notwendigerweise auf die Struktur der aufgebrachten Schicht. Auch wenn die Schicht mit diamantartiger Härte aufgebracht wird, so kann und wird die Kristallstruktur in der Regel eine amorphe Kohlenstoffstruktur sein.

Bei der Erzeugung des diamantartigen Schichtdickenabschnitts werden erfindungsgemäß die Parameter bei der Abscheidung derart eingestellt, dass graphitartig entstehende Bereiche durch nachfolgende Ätzprozesse in-situ wieder entfernt werden und dass nur diamantartig entstehende Bereiche bestehen bleiben. Solche die Ätzprozesse fördernden Parameter sind beispielsweise die Zufuhr ionisierbarer Gase wie Argon und/oder Neon in die Reaktorkammer, durch die ein zusätzlicher Ionenbeschuss bei der Abscheidung herbeigeführt wird. Ein weiterer die Ätzprozesse fördernder Parameter ist der Wasserstoffanteil in der Gasphase.

Diese Parameter können während dem Schichtwachstum variiert werden, so dass die entstehende Kohlenstoff-Hartmaskenschicht über ihre Schichtdicke in ihren Eigenschaften verändert werden kann.

Der Strukturierungsprozess kann so erfolgen, dass auf das zu strukturierende Substrat zunächst eine Kohlenstoff-Hartmaskenschicht wie angegeben aufgebracht und anschließend auf die Kohlenstoff-Hartmaskenschicht eine Photoresistschicht aufgebracht wird. Nach dem Belichten und Entwickeln der Photoresistschicht zur Erzeugung einer vorgegebenen Struktur wird diese Struktur in die Kohlenstoff-Hartmaskenschicht übertragen. Die Kohlenstoff-Hartmaskenschicht dient dann als eigentliche Ätzmaske zum Ätzen des Substrats.

Es kann ebenso vorgesehen sein, dass die Kohlenstoff-Hartmaskenschicht über eine ätzresistente Zwischenschicht strukturiert wird, die beispielsweise durch eine Siliziumoxidnitridschicht gebildet sein kann.

Als Abscheideverfahren kann vorteilhaft ein sogenanntes HDP-(high density plasma) Abscheideverfahren verwendet werden. Dies erweist sich insbesondere dann als vorteilhaft, wenn die Kohlenstoff-Hartmaskenschicht auf einer topographischen Struktur erzeugt werden soll, da sich gerade bei der Wahl dieses Abscheideverfahrens der Kohlenstoff besonders gut lunkerfrei in Löcher und Gräben eingefüllt werden kann.

Die HDP-Abscheidung kann beispielsweise bei Drücken von ca. 0,133 - 26,6 Pa durchgeführt werden und die Substrattemperatur kann in einem Bereich zwischen 200° C - 750° C, vorzugsweise 600°C - 750°C, geregelt werden.

Im übrigen sind für das HDP-Verfahren die in der DE 199 04 311 A1 enthaltenen Angaben maßgebend.

Ein HDP-Reaktor zur Erzeugung eines hochdichten Plasmas umfaßt eine zentrale Kammer, in der Halbleiter- oder Isolatorsubstrate auf einem Boot sitzen, das die Substrate nicht beeinträchtigt oder irgendwelche Verunreinigungen in die Substrate einführt. Die zentrale Kammer besteht aus einem Material, das Drücken um 0.133 Pa (1 mTorr) oder weniger widerstehen kann, bei derartigen Drücken minimal ausgast und zu keinen Verunreinigungen Anlaß gibt, die in das Innere der Kammer oder in die Substrate oder in einen darauf befindlichen Dünnfilm eindringen. Die zentrale Kammer arbeitet bei einem Betriebsdruck, der sehr viel niedriger als bei üblichen Kammern für chemische Abscheidung aus der Gasphase oder plasmagestützte chemische Abscheidung aus der Gasphase ist. Der Druck inner-halb der Kammer beträgt vorzugsweise etwa 0.67 Pa (5 mTorr), während bei der plasmagestützten chemischen Abscheidung aus der Gas-phase typischerweise ein Druck von etwa 267 Pa (2 Torr) verwendet wird. Die Plasmadichte innerhalb der Kammer ist viel höher als bei der normalen chemischen Abscheidung aus der Gasphase, selbst wenn sie plasmagestützt ist, und liegt vorzugsweise über 10¹⁶ Ionen/m³, vorzugsweise im Bereich von 10¹⁶ bis 10²² und insbesondere im Bereich von 10¹⁷ bis 10¹⁹ Ionen/m³. Die Plasmadichte könnte aber auch noch höher sein. Im Vergleich hierzu liegt beim typischen Betriebsdruck einer Kammer zur plasmagestützten chemischen Abscheidung aus der Gasphase die Plasmadichte im Bereich von 10¹⁴ bis 10¹⁶ Ionen/m³.

Ein Charakteristikum des erfindungsgemäßen Verfahrens ist, dass der Materialabscheidung eine Ionensputterätzung überlagert wird. Diese sollte beitragsmäßig so groß sein, dass sich wie bereits angedeutet ein Wachstumsselektionsprozeß herausbildet. Zu diesem Zweck kann die Schicht mit Ar-Ionen, Ne-Ionen oder auch anderen Ionen gesputtert werden. Als Kohlenstoffprekursor sind Gase wie CH₄ , C₂H₆, C₂H₄, C₂H₂ und C₃H₆ geeignet. Weiterhin vorteilhaft für die Schichtbildung ist das Zufügen relativ großer Anteile an Wasserstoff. Mit zunehmenden Ionenbeschuß und zunehmenden Wasserstoffanteil in der Gasphase werden die erzeugten Kohlenstoffschichten härter, weil beide Parameter ein Ätzen der graphitartigen Anteile in der Kohlenstoffschicht bedingen, wobei die gleichzeitig vorliegenden Diamantanteile nicht zurückgeätzt werden, da sie diesem Angriff gegenüber resistenter sind. Die so gebildete Schicht ist resistenter gegenüber Ionen-Ätzprozessen und ergibt mithin eine Hartmaske höherer Qualität. Gleichzeitig ermöglicht der simultane Abscheide-Sputterprozess ein Auffüllen von Gräben oder Löchern auf strukturierten Oberflächen. Die durch das HDP-Verfahren abgeschiedene Kohlenstoffschicht weist einen niedrigeren Wasserstoffgehalt als die durch das PECVD-Verfahren abgeschiedene Kohlenstoffschicht auf. Insbesondere kann durch geeignete Einstellung der Parameter der Wasserstoffanteil auf unter 5 % gedrückt werden. Die Kohlenstoffschicht füllt sich lunkerfrei in kleinste Strukturen mit Durchmessern unterhalb von 100 nm und ist in der Lage, Topographien zu planarisieren.

Sowohl der Ionenbeschuss als auch die Substrattemperatur können während der Abscheidung gezielt variiert werden. Dadurch wird die Bildung sogenannter Gradientenschichten möglich, d.h. mit der Schichttiefe können die optischen Eigenschaften und auch die mechanischen Eigenschaften verändert werden. Dadurch werden optimale antireflektierende Schichten erzeugt, da eine Veränderung des Brechungsindex mit der Schichttiefe eine maximale Reflexionsminderung bedeutet. Gleichzeitig kann der Prozess so gestaltet werden, dass die Härte beispielsweise in den untersten Schichtbereichen größer ist als an der Schichtoberfläche. Das ermöglicht eine optimale Prozessführung beim nachfolgenden Trockenätzprozess.

Gegebenenfalls kann als Abscheideverfahren auch ein PECVD-(plasma enhanced chemical vapor deposition) Abscheideverfahren gewählt werden. Dabei ist Voraussetzung, dass diejenige Elektrode des üblicherweise verwendeten Parallelplattenreaktors, auf der die Substrate angeordnet sind, als Kathode geschaltet wird. In diesem Fall wird ein Teil der aufwachsenden Schicht durch die Ionen wieder weggesputtert. Um erfindungsgemäß einen Wachstumsselektionsprozeß herbeizuführen, können wie beim HDP-Abscheideverfahren Elemente wie Argon, Neon u.a. zur Bildung entsprechender Ionen in verstärktem Maße dem Reaktor zugeführt werden.

Gewünschtenfalls kann das beschriebene Verfahren der Verwendung einer Kohlenstoff-Hartmaskenschicht auch mit dem eingangs beschriebenen CARL-Prozess kombiniert werden, bei welchem eine chemische Verstärkung der Resistlinien der Photoresistschicht herbeigeführt wird. Diese chemische Verstärkung kann beispielsweise durch eine nasschemische Silylierung, also die Anlagerung von Silyl-Gruppen an das organische Resistmaterial bewirkt werden, wie es beispielsweise in den Druckschriften DE 42 26 464, EP 0 395 917 oder US-5,234,793 beschrieben worden ist.

Das erfindungsgemäße Verfahren eignet sich insbesondere zur Erzeugung der bereits eingangs beschriebenen Grabenisolation in der Herstellung von Speicherzellen mit Grabenkondensator und Auswahltransistor durch den sogenannten AA-Prozess (active area). Für diesen Prozess wird derzeit eine Borsilikatglas-Hartmaske als Ätzmaske verwendet, was aus verschiedenen Gründen keine optimale Lösung ist.

Nachfolgend wird ein Ausführungsbeispiel der Durchführung des erfindungsgemäßen Verfahren in Verbindung mit den Zeichnungsfiguren näher erläutert. Es zeigen:
Fig. 1 A - F verschiedene Stadien bei der Strukturierung eines Substrats nach einer ersten Ausführungsart des erfindungsgemäßen Verfahrens unter Verwendung chemischer Resistverstärkung;
Fig.2A-E verschiedene Stadien bei der Strukturierung eines Substrats nach einer zweiten Ausführungsart des erfindungsgemäßen Verfahrens unter Verwendung einer ätzresistenten Zwischenschicht.

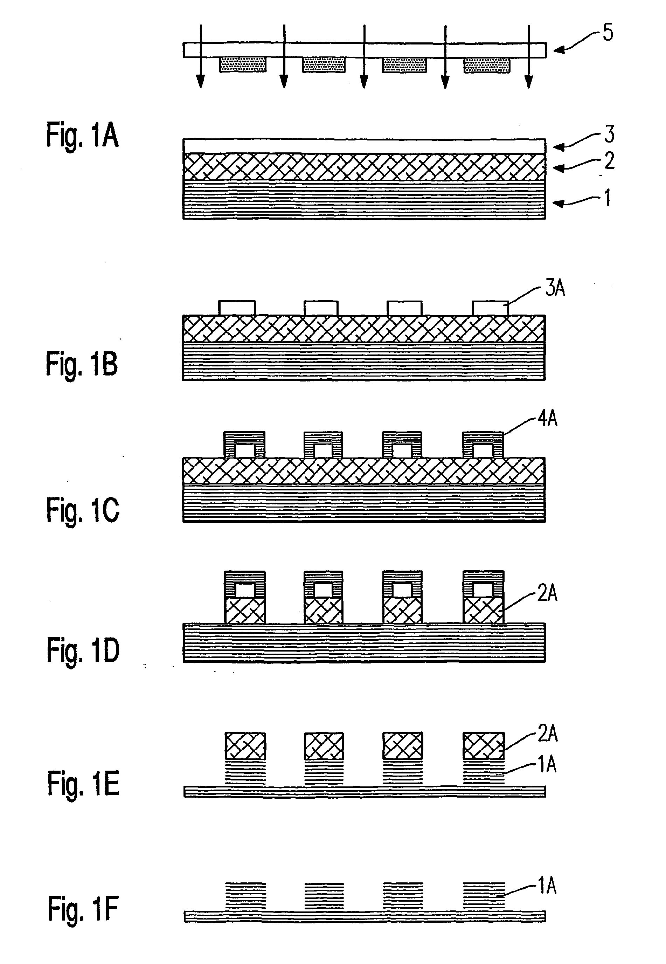

Gemäß Fig. 1A wird zunächst ein zu strukturierendes Substrat 1 bereitgestellt, bei welchem es sich beispielsweise um einen Chip bzw. Wafer handeln kann, in welchen bereits eine matrixförmige Anordnung aus Grabenkondensatoren prozessiert worden ist, die jeweils Speicherzellen zugehörig sind. Durch den hier im folgenden beispielhaft dargestellten Strukturierungsprozess sollen zwischen den Grabenkondensatoren Isolationsgebiete (STI) erzeugt werden. Da die zur Erzeugung der Isolationsgebiete zu entfernenden Abschnitte auch jeweils Teilabschnitte der prozessierten Grabenkondensatoren enthalten, muss demzufolge auch Siliziumoxid geätzt werden, da die Grabenkondensatoren im allgemeinen einen aus Siliziumoxid bestehenden Isolationskragen aufweisen.

Auf dem solchermaßen vorprozessierten Substrat 1 wird nun zunächst eine Kohlenstoff-Hartmaskenschicht 2 aufgebracht. Die Erzeugung der Kohlenstoff-Hartmaskenschicht 2 erfolgt wie beschrieben durch ein plasmaunterstütztes Abscheideverfahren. Bei dem genannten Anwendungsfall der Vorbereitung von Isolationsgebieten liegt im allgemeinen eine topographische Struktur vor, bei der es vorteilhaft ist, für die Abscheidung der Kohlenstoff-Hartmaskenschicht 2 ein HDP-Verfahren zu wählen, damit sich der Kohlenstoff lunkerfrei in alle vorhandenen Gräben und Löcher einfüllt. Die Dicke der Kohlenstoff-Hartmaskenschicht 2 liegt im Bereich 50 - 300 nm.

Durch das erfindungsgemässe Verfahren wird es darüber hinaus möglich, die Kohlenstoff-Hartmaskenschicht 2 prozessangepasst mit optimalen schichtdickenabhängigen Eigenschaften herzustellen. Die Hartmaskenschicht 2 kann beispielsweise als Gradientenschicht derart ausgebildet sein, dass sie nur in einem unteren Schichtdickenabschnitt diamantartige Struktur aufweist, in einem oberen Schichtdickenabschnitt jedoch optimale antireflektierende Eigenschaften aufweist. Letztere bedingen möglicherweise, dass die Struktur keine diamantartige Struktur, sondern eine mehr graphitartige Struktur mit einem bestimmten höheren Wasserstoffanteil aufweist. Der grosse Vorteil des HDP-Verfahrens gegenüber dem PECVD-Verfahren liegt darin, dass sich die die Struktur der abzuscheidenden Schicht bestimmenden Parameter während der Schichtabscheidung besser variieren lassen. Wenn ein Übergang von einer amorphen, graphitartigen Struktur zu einer diamantartigen Struktur erzeugt werden soll, so muß beispielsweise nur der Anteil des zugeführten Wasserstoffs und/oder der Anteil zusätzlicher ionisierbarer Gase wie Argon oder Neon auf einen bestimmten Wert gesteigert werden. Durch die dann zunehmenden Ätzprozesse kann die Struktur nicht mehr graphitartig aufwachsen, so dass nur noch die diamantartig entstehenden Strukturen von Bestand sind.

Anschließend wird auf die erzeugte Struktur eine Schicht 3 eines positiven Photoresists abgeschieden. Diese Photoresistschicht 3 wird dann durch konventionelle Belichtung mittels einer Chrommaske 5 belichtet, anschließend werden die belichteten Bereiche entfernt, so dass Resistbereiche 3A auf der Kohlenstoff-/Hartmaskenschicht 2 zurückbleiben. Das Ergebnis ist in Fig. 1B dargestellt.

Anschließend wird eine chemische Verstärkung der Resistbereiche 3A durch eine nasschemische Silylierung durchgeführt, bei welcher sich Silyl-Gruppen an das organische Material der Photoresistbereiche 3A anlagern, so dass um die Resistbereiche 3A Verstärkungsbereiche 4A aus Silyl-Gruppen gebildet werden. Das Ergebnis ist in der Fig. 1C dargestellt.

Im nächsten Schritt erfolgt die Öffnung der Kohlenstoff-Hartmaskenschicht 2, die beispielsweise durch einen anisotropen Trockenätzprozess mit einen O₂-Plasma durchgeführt werden kann, bei welchem die verstärkten Resistbereiche 3A als Ätzmaske wirken. Die Ätzung wird zunächst nur bis zu der Oberfläche des Substrats 1 durchgeführt. Unterhalb der verstärkten Resistbereiche 3A entstehen durch diesen Ätzschritt Maskenbereiche 2A der Kohlenstoff-Hartmaskenschicht, die für den nachfolgenden Ätzschritt an dem Substrat 1 als Ätzhartmaske dienen. Das Ergebnis ist in der Fig. 1D dargestellt.

Anschließend wird der eigentliche Strukturierungsprozess des Substrats 1 durch einen anisotropen Trockenätzschritt durchgeführt, bei welchem die Maskenbereiche 2A als Ätzhartmaske dienen. Der Trockenätzschritt kann beispielsweise mit einem O₂-Plasma erfolgen. Unterhalb der Maskenbereiche 2A verbleiben ungeätzte Substratbereiche 1A, in denen beispielsweise in dem obengenannten Anwendungsfall der Erzeugung von Isolationsgebieten fertig prozessierte Grabenkondensatoren und Ausfalltransistoren von Speicherzellen angeordnet sein können. Das Ergebnis ist in der Fig. 1E dargestellt.

Schließlich können in einem letzten Verfahrensschritt die Maskenbereiche 2A durch einen einfachen Stripping-Prozess mit einem O₂-Plasma entfernt werden. Das in Form der Substratbereiche 1A strukturierte Substrat 1 ist in der Fig. 1F dargestellt.

Für die Erzeugung von Isolationsbereichen müssen in einem späteren, nicht dargestellten Verfahrensschritt die freigeätzten Bereiche durch ein geeignetes Isolationsmaterial aufgefüllt werden.

Die in den Fig. 1D-F dargestellten Verfahrensschritte können gegebenenfalls in einer einzigen Reaktionskammer nacheinander durchgeführt werden.

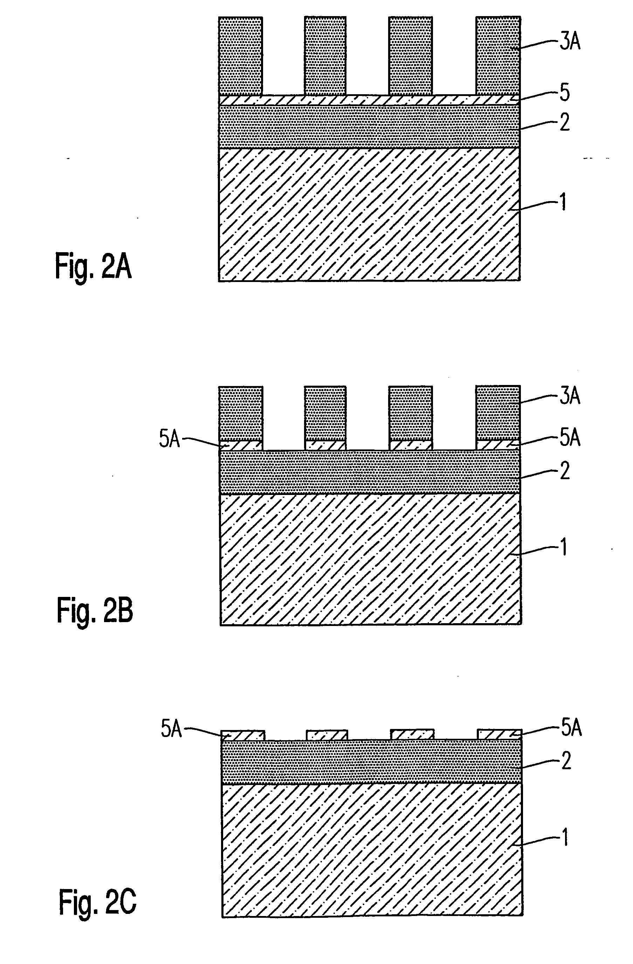

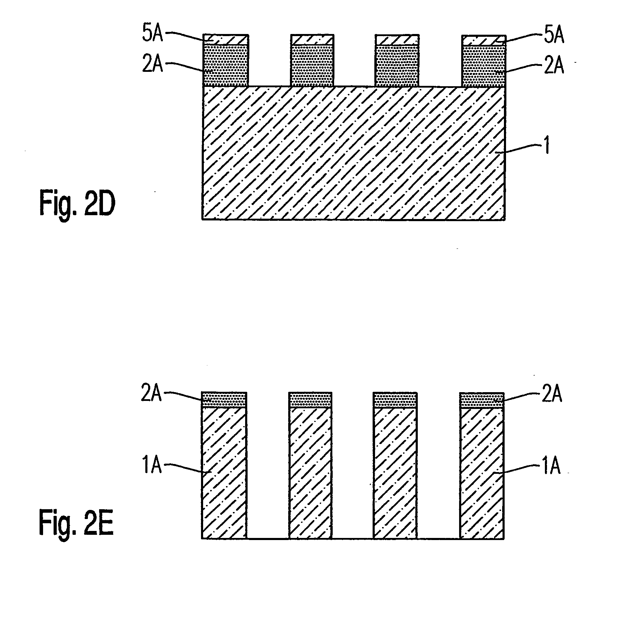

Gemäß Fig.2A wird auf ein zu strukturierendes Substrat 1 nach einem erfindungsgemäßen plasmaunterstützten Abscheideverfahren eine Kohlenstoff-Hartmaskenschicht 2 abgeschieden. Auf diese wird dann beispielsweise durch ein PECVD-Verfahren eine ätzresistente Zwischenschicht 5 aufgebracht, die beispielsweise durch eine ca. 25 nm dicke Siliziumoxidnitrid (SiON) gebildet sein kann. Die Zwischenschicht 5 muß eine ausreichende Ätzresistenz bei der Ätzung der Kohlenstoff-Hartmaskenschicht 2 aufweisen. Auf die Zwischenschicht 5 wird dann die Photoresistschicht aufgebracht und strukturiert, so dass maskierte Bereiche 3A stehenbleiben.

Gemäß Fig.2B wird anschließend zunächst die Struktur der Photoresistschicht in die Zwischenschicht 5 übertragen, so dass maskierte Bereiche 5A der Zwischenschicht 5 unterhalb der maskierten Bereiche 3A der Photoresistschicht resultieren. Die SiON-Schicht 5 kann in einem Trockenätzprozeß mit Ätzgasen wie Ar, CHF3, CF4 o.ä. beispielsweise in einem MERIE-Reaktor geätzt werden. Denkbar sind ebenso ICP-, ECR- oder andere Plasmaätzreaktoren.

Gemäß Fig.2C werden die maskierten Photoresistbereiche 3A in einem Standardlackierascher entfernt.

Dann wird entsprechend Fig.2D die Kohlenstoff-Hartmaskenschicht 2 strukturiert, so dass maskierte Bereiche 2A unterhalb der maskierten SiON-Bereiche 5A gebildet werden. Dies kann vorzugsweise in einem Trockenätzprozeß in einem MERIE-Reaktor unter Verwendung von O₂- und/oder N₂-Ätzmedien durchgeführt werden. Diese Ätzung kann mit hoher Selektivität zu den maskierten SiON-Bereichen 5A durchgeführt werden. Hierbei kann auch in-situ der Photolack entfernt werden, so dass der Zwischenschritt der Fig.2C unter Verwendung des Standardlackieraschers eingespart wird.

Anschließend wird wie bereits in Verbindung mit Fig.1 beschrieben, das Substrat 1 mittels der maskierten Kohlenstoff-Hartmaskenbereiche 2A strukturiert, so dass strukturierte Substratbereiche 1A gebildet werden.

## Patentansprüche

1. Verfahren zur photolithographischen Erzeugung von Strukturen in einem Substrat (1), bei welchem
a) durch ein plasmaunterstütztes Abscheideverfahren eine Kohlenstoff-Hartmaskenschicht (2) auf das Substrat (1) aufgebracht wird, wobei die Abscheidung derart durchgeführt wird, dass die Kohlenstoff-Hartmaskerischicht (2) in mindestens einem Schichtdickenabschnitt eine einem Diamanten vergleichbare Härte aufweist,
b) die Kohlenstoff-Hartmaskenschicht (2) strukturiert wird, und
c) die Struktur der Kohlenstoff-Hartmaskenschicht (2) in das Substrat (1) übertragen wird,
**dadurch gekennzeichnet, dass**
- im Verfahrensschritt a) bei der Erzeugung des diamantartigen Schichtdickenabschnitts die Parameter bei der Abscheidung derart eingestellt werden, dass graphitartig entstehende Bereiche durch nachfolgende Ätzprozesse wieder entfernt werden und dass entstehende Bereiche diamantartiger Härte bestehen bleiben.

2. Verfahren nach Anspruch 1,
**dadurch gekennzeichnet, dass**
- ein zusätzlicher Ionenbeschuss bei der Abscheidung, insbesondere durch Einbringen von Ar und/oder Ne herbeigeführt wird, und/oder
- Wasserstoff zugeführt wird.

3. Verfahren nach Anspruch 1 oder 2,
**dadurch gekennzeichnet, dass**
- im Verfahrensschritt a) als Kohlenstoffprekursor eines oder mehrere der Gase CH₄, C₂H₆, C₂H₄, C₂H₂ und C₃H₆ verwendet werden.

4. Verfahren nach einem der vorherigen Ansprüche,
**dadurch gekennzeichnet, dass**
- im Verfahrensschritt a) ein HDP-Abscheideverfahren verwendet wird.

5. Verfahren nach einem der vorherigen Ansprüche,
**dadurch gekennzeichnet, dass**
- bei der Erzeugung des diamantartigen Schichtdickenabschnitts eine Substrattemperatur von 200°C-750°C eingestellt wird.

6. Verfahren nach einem der vorherigen Ansprüche,
**dadurch gekennzeichnet, dass**
- im Verfahrensschritt a) ein PECVD-Abscheideverfahren verwendet wird.

7. Verfahren nach einem der vorherigen Ansprüche,
**dadurch gekennzeichnet, dass**
- im Verfahrensschritt b) auf die Kohlenstoff-Hartmaskenschicht (2) eine Photoresistschicht (3) aufgebracht, photolithographisch strukturiert und die Struktur in die Kohlenstoff-Hartmaskenschicht (2) übertragen wird.

8. Verfahren nach Anspruch 7,
**dadurch gekennzeichnet, dass**
- zwischen die Kohlenstoff-Hartmaskenschicht (2) und die Photoresistschicht (3) eine Zwischenschicht (5) eingebracht wird, und
- die in der Photoresistschicht (3) erzeugte Struktur in die Zwischenschicht (5) übertragen wird und anschließend in die Kohlenstoff-Hartmaskenschicht (2) übertragen wird.

9. Verfahren nach Anspruch 7 oder 8,
**dadurch gekennzeichnet, dass**
- die Photoresistschicht (3) nach ihrer Strukturierung chemisch verstärkt wird.

10. Verfahren nach einem der vorherigen Ansprüche,
**dadurch gekennzeichnet, dass**
- die Kohlenstoff-Hartmaskenschicht (2) als Gradientenschicht ausgebildet wird.

11. Verfahren nach Anspruch 10,
**dadurch gekennzeichnet, dass**
- der Verfahrensschritt a) derart durchgeführt wird, dass die Kohlenstoff-Hartmaskenschicht (2) tiefenabhängig in ihrer Zusammensetzung und/oder ihrer Struktur variiert.

12. Verfahren zur Herstellung von Isolationsbereichen zwischen in einem Substrat (1) ausgebildeten Bauelementen bei welchen
- das Substrat (1) nach einem oder mehreren der vorherigen Ansprüche strukturiert wird, und
- die entfernten Bereiche durch ein isolierendes Material aufgefüllt werden.

## Claims

1. Process for the photolithographic production of patterns in a substrate (1), in which
a) a carbon hard mask layer (2) is applied to the substrate (1) by a plasma-enhanced deposition process, the deposition being carried out in such a manner that the carbon hard mask layer (2), in at least one layer thickness section, has a hardness comparable to that of diamond,
b) the carbon hard mask layer (2) is patterned, and
c) the pattern of the carbon hard mask layer (2) is transferred to the substrate (1),
**characterized in that**
- in process step a), during the production of the diamond-like layer thickness section, the parameters used for the deposition are set in such a manner that graphite-like regions which are formed are removed again by subsequent etching processes, and **in that** regions with a diamond-like hardness which are formed are retained.

2. Process according to Claim 1, **characterized in that**
- additional ion bombardment is brought about during the deposition, in particular through the introduction of Ar and/or Ne, and/or
- hydrogen is supplied.

3. Process according to Claim 1 or 2, **characterized in that**
- in process step a), one or more of the gases CH₄, C₂H₆, C₂H₄, C₂H₂ and C₃H₆ are used as carbon precursor.

4. Process according to one of the preceding claims,
**characterized in that**
- an HDP deposition process is used in process step a).

5. Process according to one of the preceding claims,
**characterized in that**
- a substrate temperature of from 200°C-750°C is set during the production of the diamond-like layer thickness section.

6. Process according to one of the preceding claims,
**characterized in that**
- a PECVD deposition process is used in process step a).

7. Process according to one of the preceding claims,
**characterized in that**
- in process step b), a photoresist layer (3) is applied to the carbon hard mask layer (2), is patterned by photolithography and the pattern is transferred to the carbon hard mask layer (2).

8. Process according to Claim 7, **characterized in that**
- an interlayer (5) is introduced between the carbon hard mask layer (2) and the photoresist layer (3), and
- the pattern produced in the photoresist layer (3) is transferred to the interlayer (5) and is then transferred to the carbon hard mask layer (2).

9. Process according to Claim 7 or 8,
**characterized in that**
- the photoresist layer (3) is chemically amplified after it has been patterned.

10. Process according to one of the preceding claims,
**characterized in that**
- the carbon hard mask layer (2) is formed as a gradient layer.

11. Process according to Claim 10, **characterized in that**
- the process step a) is carried out in such a manner that the composition and/or the pattern of the carbon hard mask layer (2) varies as a function of its depth.

12. Process for producing insulation regions between components formed in a substrate (1), in which
- the substrate is patterned as described in one or more of the above claims, and
- the removed regions are filled with an insulating material.

## Revendications

1. Procédé de production photolithographique de structures dans un substrat (1), dans lequel
a) on dépose par un procédé de dépôt assisté par plasma une couche (2) de masque dure en carbone sur le substrat (1), le dépôt étant effectué de manière à ce que la couche (2) de masque dure en carbone ait dans au moins une partie de l'épaisseur de couche une dureté comparable à un diamant,
b) on structure la couche (2) de masque dure en carbone et
c) on transfère la structure de la couche (2) de masque dure en carbone au substrat (1),
**caractérisé en ce que**
- on règle dans le stade a) du procédé, lors de la production de la partie d'épaisseur de couche analogue à du diamant, les paramètres lors du dépôt, de façon à rééliminer par des opérations d'attaque ultérieures des parties se formant à la façon du graphite et à laisser subsister des parties se formant en ayant la dureté du diamant.

2. Procédé suivant la revendication 1,
**caractérisé en ce que**
- on provoque un bombardement ionique supplémentaire lors du dépôt, notamment par introduction d'Ar et/ou de Ne et/ou
- on envoie de l'hydrogène.

3. Procédé suivant la revendication 1 ou 2,
**caractérisé en ce que**
- dans le stade a) du procédé on utilise comme précurseur de carbone un ou plusieurs des gaz CH₄, C₂H₆, C₂H₄, C₂H₂ et C₃H₆.

4. Procédé suivant l'une des revendications précédentes,
**caractérisé en ce que**
- au stade a) du procédé on utilise un procédé de dépôt HDP.

5. Procédé suivant l'une des revendications précédentes,
**caractérisé en ce que**
- lors de la production de la partie d'épaisseur de couche du type du diamant on établit une température du substrat de 200°C à 750°C.

6. Procédé suivant l'une des revendications précédentes,
**caractérisé en ce que**
- au stade a) du procédé on utilise un procédé de dépôt PECVD.

7. Procédé suivant l'une des revendications précédentes,
**caractérisé en ce que**
- au stade b) du procédé on dépose sur là couche (2) de masque dure en carbone une couche (3) de réserve photosensible, on la structure photolithographiquement et on transfère la structure dans la couche (2) de masque dure en carbone.

8. Procédé suivant la revendication 7,
**caractérisé en ce que**
- on introduit une couche (5) intermédiaire entre la couche (2) de masque dure en carbone et la couche (3) de réserve photosensible et
- on transfère la structure produite dans la couche (3) de réserve photosensible à la couche (5) intermédiaire et on la transfère ensuite à la couche (2) de masque dure en carbone.

9. Procédé suivant la revendication 7 ou 8,
**caractérisé en ce que**
- on renforce chimiquement la couche (3) de réserve photosensible après sa structuration.

10. Procédé suivant l'une des revendications précédentes,
**caractérisé en ce que**
- on forme la couche (2) de masque dure en carbone sous la forme d'une couche à gradient.

11. Procédé suivant la revendication 10,
**caractérisé en ce que**
- on effectue le stade a) du procédé en modifiant en fonction de la profondeur la composition et/ou la structure de la couche (2) de masque dure en carbone.

12. Procédé de production de parties d'isolement entre des composants constitués dans un substrat (1), dans lequel
- on structure le substrat suivant l'une ou plusieurs des revendications précédentes et
- on remplit les parties éliminées d'un matériau isolant.
